# EUROPEAN PATENT SPECIFICATION

(11) **EP 1 104 939 B1**
(45) Date of publication and mention of the grant of the patent: **12.06.2002**
(21) Application number: 99830728.4
(22) Date of filing: 25.11.1999
(51) Int. Cl.: H01L 27/15

(54) **Light emitting device using an electroluminescent organic material, having sub-structured sources**
Lichtemittierende Vorrichtung unter Verwendung von organischem, elektrolumineszenten Material, mit unterteilten Lichtquellen
Dispositif émettant de la lumière comprenant un matériau organique électroluminescent, ayant des sources subdivisées

(43) Date of publication of application: 06.06.2001
(73) Proprietor: C.R.F. Società Consortile per Azioni, 10043 Orbassano (TO) (IT)
(72) Inventor: Perlo, Piero, C.R.F. Societa Consortile per Azioni, 10043 Orbassano (Torino) (IT); Repetto, Piermario, CRF Soc. Consortile per Azioni, 10043 Orbassano (Torino) (IT); Sinesi, Sabino, CRF Soc. Consortile per Azioni, 10043 Orbassano (Torino) (IT); Lambertini, Vito, CRF Soc. Consortile per Azioni, 10043 Orbassano (Torino) (IT); Pullini, Daniele, CRF Soc. Consortile per Azioni, 10043 Orbassano (Torino) (IT)
(74) Representative: Notaro, Giancarlo

(56) References cited:
- EP-A- 0 734 078
- WO-A-97/38445
- GU G ET AL: "HIGH-EXTERNAL-QUANTUM-EFFICIENCY ORGANIC LIGHT-EMITTING DEVICES" OPTICS LETTERS,US,OPTICAL SOCIETY OF AMERICA, WASHINGTON, vol. 22, no. 6, 15 March 1997 (1997-03-15), pages 396-398, XP000690337 ISSN: 0146-9592

## Description

The present invention relates to light emitting devices using luminescent organic materials of so-called LEP (Light Emitting Polymers) or OLED (Organic Light Emitting Devices) type. Such devices are disclosed for example in "High-External Quantum-Efficiency Organic Light-Emitting Device", Garbuzov at al., OPTICS LETTERS, vol. 22, n.6, 15 March 1997.

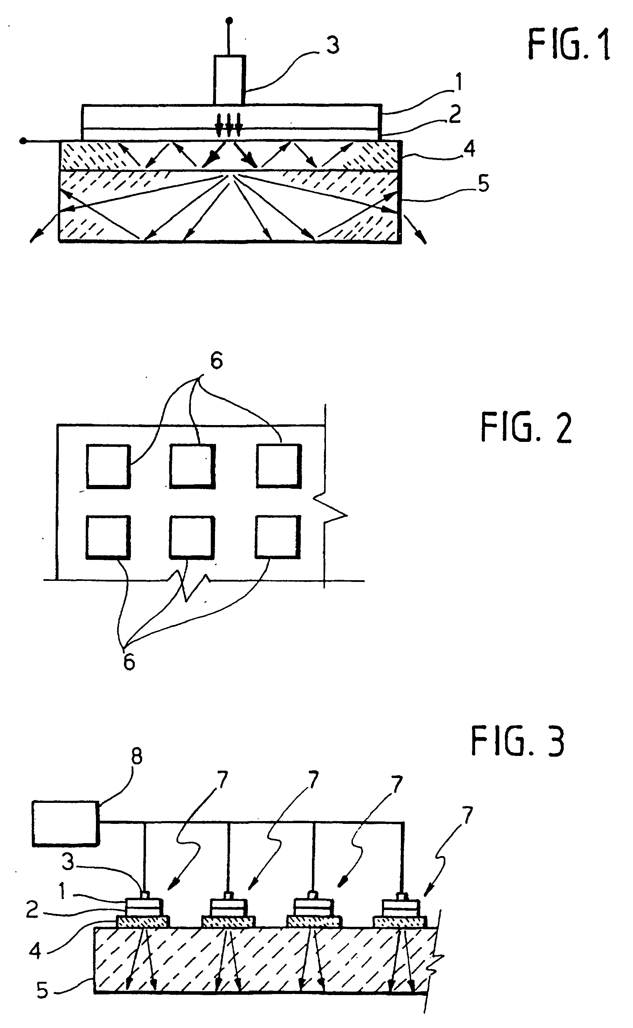

The devices of the above indicated type (see figure 1 of the annexed drawings) commonly have a first layer 1 of electro-luminescent material, such as Alq₃, having for instance a thickness of 80nm, and a second layer 2 of equal thickness constituted by a material such as N, N'-diphenyl-N,N'-bis(3-methylphenyl)1-1'biphenyl-4,4'diamine (TPD). At the rear of layer 1 an electrode is applied, whereas at the front layer 2 is covered by a transparent plate 4 acting as electrode tipically constituted by ITO (Indium Tin Oxide), having a thickness of about 150nm. The above described structure is then covered by a substrate plate 5, such as of glass or plastics, having a thickness for instance 1.1 mm.

The light-emitting devices of the above indicated type have a very high efficiency, but have also the drawback that only a small portion of the generated light (generally in the order of 20-30% at maximum) is able to get out of the device, the large remaining part being instead wasted through a sequence of reflections inside the transparent plates, due to a wave guide effect. The light flow at the output is generally proportional to the current supplied to the two electrodes of the device, so that one may try to overcome the above mentioned drawback by increasing the supplied current. However, in this manner, the average life of the device is substantially reduced.

The above identified publication discloses a temptative solution to the above mentioned problem in which the structure of the device has a substrate shaped so as to define a plurality of emitting sources located at the apices of piramids or cones with reflective lateral surfaces which reflect the emitted rays with a large divergence angle with respect to the sources, so as to cause these rays to get out at the front of the device, thus avoiding the wave guide effect which has been described above. However, this solution has the drawback to be complicated and costly to manufacture.

The object of the present invention is that of providing a simple and efficient solution to the problem which has been indicated in the foregoing, particularly in view of being applied to display and lighting systems.

In view of achieving in this object, the invention provides a light emitting device using an organic material, comprising a plurality of emitting sources each including at least one layer of electro-luminescent organic material, a layer of transparent metal material acting as electrode superposed on the layer of luminescent material, and a substrate plate superposed on the transparent electrode, as well as an electrode applied at the rear of the layer of electro-luminescent material and means for suppling an electric voltage to said electrodes, so as to cause emission of light from the layer of electro-luminescent material, characterised in that each light emitting source is sub-structured into a plurality of emitting cells having dimensions not greater than 5 micrometers, preferably not greater than 2 micrometers, and in that said voltage supply means are adapted to supply all the above mentioned cells simultaneously and substantially in phase with each other, to generate a substantially coherent light beam having a relatively reduced divergence angle.

Due to the above mentioned features, the portion of the generated light which gets out of the device becomes drammatically greater than that in the known devices and may be for instance in the order of 50-60% of the total generated light. Each cell into which each source is sub-structured becomes a source of coherent light. By suppling all the cells simultaneously and in phase with each other a light beam is obtained having a high coherence degree, a limited divergence degree, controlled in direction and substantially similar to a laser beam.

The invention will now be described with reference to the annexed drawings, given purely by way of non limiting example, in which:
figure 1, already described, shows a light emitting device according to the prior art, and
figures 2, 3 are a front and a cross-sectional diagrammatic view of a device according to the invention.

With reference to figure 2, the device according to the invention has a plurality of emitting sources 6, arranged in a matrix, each having a structure similar to that shown in figure 1. According to the invention, each source 6 is sub-structured into a matrix of a small cell 7 (figure 3) each having a dimension not greater than 5 micrometers and preferably not greater than 2 micrometers, such as about 1-2 micrometers. Each cell 7, taken alone, has a structure similar to the known structure shown in figure 1, with the two layers 1, 2 for generating light, the two electrodes 3, 4, the latter being a plate of transparent material (such as ITO) and substrate plate 5, such as of glass or plastics, applied over all the cells 7. The thickness of the various layers may be similar to that indicated with reference to figure 1. The electrodes of the various cells 7 are supplied by electric supply means 8 adapted to supply these cells simultaneously and substantially in phase with each other. The reduced dimension of each cell and the phase supply cause the cell to emit substantially coherent light beams, having a reduced divergence angle, and controlled in direction, so that a percentage up to 50-60% of the generated light can be extracted from the device. Therefore, differently from the known devices, in the device according to the invention the quantity of light which remains trapped inside the device due to a wave guide effect may be lower than the quantity of emitted light.

Due to these features, the device may be supplied with a relatively low current, which greatly increases the life of the device according to the invention with respect to the known devices.

The device according to the invention may lands itself to the production of lamps, both for lighting systems and display panels with an efficiency even eight times greater than that of the prior devices.

Naturally, while the principle of the invention remains the same, the details of construction and the embodiments may widely vary with respect to what has been described and illustrated purely by way of example, without departing from the scope of the present invention.

## Claims

1. Light emitting device using an organic material, preferably for displays and lighting systems comprising a plurality of emitting sources (6), each including at least one layer (1, 2) of electro-luminescent organic material, a layer (4) of transparent metal material, acting as electrode, superposed on the layer of electro-luminescent material (1, 2), a substrate plate (5) superposed on the transparent electrode (4), an electrode (3) applied at the rear of the layer of electro-luminescent material (1, 2), and means (8) for suppling an electric voltage to said electrode, so as to cause the emission of light from the layer of electro-luminescent material (1, 2), **characterised in that** each emitting source is sub-structured into a matrix of emitting cells (7) of dimensions not greater than 5 micrometers, preferably not greater than 2 micrometers, and that said electric supply means (8) are adapted to supply all or part of said cells (7) simulteously and substantially in phase with each other.

2. Device according to claim 1, **characterised in that** two layers (1, 2) of organic material are provided superposed on each other.

3. Device according to claim 1, **characterised in that** the transparent electrod (4) is constituted by ITO (Indium Tin Oxide).

4. Display using a light emitting organinc material, **characterised in that** it has pixels sub-structured into micropixels, according to any of the previous claims.

## Patentansprüche

1. Lichtemittierende Vorrichtung unter Verwendung eines organischen Materials, vorzugsweise für Displays und Beleuchtungssysteme, umfassend eine Mehrzahl von emittierenden Quellen (6), von denen jede wenigstens eine Schicht (1, 2) aus organischem, elektrolumineszentem Material umfaßt, eine Schicht (4) aus transparentem, metallischen Material, die als Elektrode dient und über der Schicht aus elektrolumineszentem Material (1, 2) angeordnet ist, eine Substratplatte (5), die über der transparenten Elektrode (4) angeordnet ist, eine Elektrode (3), die auf der Rückseite der Schicht aus elektrolumineszentem Material (1, 2) angebracht ist, und eine Vorrichtung (8) für die Versorgung der Elektrode mit elektrischer Spannung, so daß die Emission von Licht aus der Schicht aus elektrolumineszentem Material (1, 2) hervorgerufen wird, **dadurch gekennzeichnet, daß** jede emittierende Quelle unterteilt ist in eine Matrix aus emittierenden Zellen (7) mit Abmessungen, die 5 Mikrometer, vorzugsweise 2 Mikrometer, nicht übersteigen, und daß die Stromversorgungsvorrichtung (8) für die Versorgung aller oder eines Teils der Zellen (7) ausgelegt ist, und zwar gleichzeitig und phasengleich miteinander.

2. Vorrichtung nach Anspruch 1, **dadurch gekennzeichnet, daß** zwei Schichten (1, 2) aus organischem Material übereinander angeordnet vorgesehen sind.

3. Vorrichtung nach Anspruch 1, **dadurch gekennzeichnet, daß** die transparente Elektrode (4) aus ITO (Indiumzinnoxid) besteht.

4. Display unter Verwendung eines lichtemittierenden, organischen Materials, **dadurch gekennzeichnet, daß** es Pixel aufweist, die in Mikropixel unterteilt sind, gemäß einem der vorhergehenden Ansprüche.

## Revendications

1. Dispositif émettant une lumière, comprenant un matériau organique, de préférence pour des dispositifs d'affichage et des systèmes d'éclairage, comprenant une pluralité de sources d'émission (6) incluant chacune au moins une couche (1,2) d'un matériau organique électroluminescent, une couché (4) d'un matériau métallique transparent, agissant en tant qu'électrode, superposé à la couche du matériau électroluminescent (1,2), une plaque formant substrat (5) superposée à l'électrode transparente (4), une électrode (3) appliquée à l'arrière de la couche du matériau électroluminescent (1,2) et des moyens (8) pour délivrer une tension électrique à ladite électrode de manière à provoquer l'émission d'une lumière à partir de la couche du matériau électroluminescent (1,2), **caractérisé en ce que** chaque source d'émission est structurée en une matrice de cellules d'émission (7) ayant des dimensions non supérieures à 5 micromètres, de préférence non supérieures à 2 micromètres, et que lesdits moyens d'alimentation électrique (8) sont adaptés pour alimenter la totalité ou une partie desdites cellules (7) simultanément et essentiellement en phase entre elles.

2. Dispositif selon la revendication 1, **caractérisé en ce que** deux couches (1,2) du matériau organique superposées l'une à l'autre sont prévues.

3. Dispositif selon la revendication 1, **caractérisé en ce que** l'électrode transparente (4) est constituée par du ITO (oxyde d'indium et d'étain).

4. Dispositif d'affïchage comportant un matériau organique émettant une lumière, **caractérisé en ce qu'**il comporte des pixels sous-structurés en micropixels selon l'une quelconque des revendications précédentes
